# EUROPEAN PATENT SPECIFICATION

(11) **EP 4 202 977 B1**
(45) Date of publication and mention of the grant of the patent: **24.07.2024**
(21) Application number: 22214363.8
(22) Date of filing: 16.12.2022
(51) Int. Cl.: H01L 21/285

(54) **TITANIUM CONTACT FORMATION**
HERSTELLUNG EINES TITANKONTAKTS
FORMATION D'UN CONTACT EN TITANE

(30) Priority: 22.12.2021 US 202117559897
(43) Date of publication of application: 28.06.2023
(73) Proprietor: Intel Corporation, Santa Clara, CA 95054 (US)
(72) Inventor: NANDI, Debaleena, Hillsboro, 97124 (US); DEWEY, Gilbert, Beaverton, 97006 (US); GHANI, Tahir, Portland, 97229 (US); HARATIPOUR, Nazila, Portland, 97239 (US); KOBRINSKY, Mauro J., Portland, 97229 (US); MURTHY, Anand, Portland, 97229 (US)
(74) Representative: 2SPL Patentanwälte PartG mbB

(56) References cited:
- EP-A2- 1 063 686
- US-A1- 2002 043 722
- US-A1- 2020 098 572
- US-B1- 6 174 805
- US-B1- 7 407 882

## Description

### BACKGROUND

Titanium contacts can be used to provide electrically conductive connections to silicon germanium (SiGe) or silicon source/drain regions of field-effect transistors. Titanium contacts have an associated parasitic resistance that, if large enough, can affect transistor performance.

US 2020/098572 A1 discloses a method of forming a semiconductor device including forming a source/drain region on a substrate, depositing a metal-rich metal silicide layer on the source/drain region, depositing a silicon-rich metal silicide layer on the metal-rich metal silicide layer, and forming a contact plug on the silicon-rich metal silicide layer. This disclosure also describes a semiconductor device including a fin structure on a substrate, a source/drain region on the fin structure, a metal-rich metal silicide layer on the source/drain region, a silicon-rich metal silicide layer on the metal-rich metal silicide layer, and a contact plug on the silicon-rich metal silicide layer.

EP 1 063 686 A2 discloses a method of forming a silicide layer in contact with a silicon substrate. The method comprises forming the silicide layer by supplying a silicon-containing source that is different from the silicon substrate, such that the silicon in the silicide layer originates primarily from the silicon-containing source.

US 6 174 805 B1 discloses a titanium film forming method. Before a titanium film is formed, the temperature in a reaction chamber for forming the titanium film is set to a temperature or more at which hydrogen chloride is produced by chlorine and hydrogen. A hydrogenated gas is then fed into the reaction chamber for a predetermined period of time. With this process, before the titanium film is formed, chlorine gas and titanium chloride gas left in the reaction chamber for forming the titanium film are reduced.

US 7 407 882 B1 discloses a method for manufacturing the semiconductor component. A layer of dielectric material is formed over a semiconductor substrate. An opening having sidewalls is formed in the dielectric layer and exposes a portion of the semiconductor substrate. Titanium silicide is disposed on the dielectric layer, sidewalls, and the exposed portion of the semiconductor substrate. The titanium silicide may be formed by disposing titanium on the dielectric layer, sidewalls, and exposed portion of the semiconductor substrate and reacting the titanium with silane. Alternatively, the titanium silicide may be sputter deposited. A layer of titanium nitride is formed on the titanium silicide. A layer of tungsten is formed on the titanium nitride. The tungsten, titanium nitride, and titanium silicide are polished to form the contact structures.

US 2002/043722 A1 discloses a method comprising the steps of: (a) forming an insulating film on a semiconductor substrate on which an element is formed; (b) selectively removing a predetermined region of the insulating film to form an opening portion so as to expose an underlying conductive layer; (c) depositing a refractory metal on the opening portion; (d) depositing refractory metal silicide on the refractory metal deposited on the opening portion; and (e) filling the opening portion by depositing a refractory nitride metal on the refractory metal silicide deposited on the opening portion.

### BRIEF DESCRIPTION OF THE DRAWINGS

FIGS. 1A-1D illustrate a first example simplified process sequence for forming a titanium contact to silicon germanium.
FIGS. 2A-2D illustrate a second example simplified process sequence for forming a titanium contact to silicon germanium.
FIG. 3 is an example method of forming a titanium contact.
FIG. 4 is a top view of a wafer and dies that may be included in a microelectronic assembly, in accordance with any of the embodiments disclosed herein.
FIG. 5 is a cross-sectional side view of an integrated circuit device 500 that may include titanium contacts according to the technologies disclosed herein.
FIGS. 6A-6D are perspective views of an example planar FET, FinFET, gate-all-around FET, and stacked gate-all-around FET.
FIG. 7 is a cross-sectional side view of an integrated circuit device assembly that may include a microelectronic assembly, in accordance with any of the embodiments disclosed herein.
FIG. 8 is a block diagram of an example electrical device that may include a microelectronic assembly, in accordance with any of the embodiments disclosed herein.

### DETAILED DESCRIPTION

The source/drain regions of PMOSFETs (p-type metal-oxide-silicon field-effect transistors (FETs)) can comprise p-type silicon germanium (SiGe) layers epitaxially grown on a bulk silicon, silicon-on-insulator or another suitable substrate. Silicon germanium source/drain regions can introduce strain into the channel region of a MOSFET and the induced strain can cause the silicon atoms in the channel to stretch further apart than they would be in the absence of strain. This increased atomic spacing results in increased charge carrier mobility in the channel region, which can translate into increased transistor drive current.

The formation of a titanium contact to a silicon germanium layer can comprise the formation of a titanium silicide layer positioned adjacent to the silicon germanium layer. The titanium silicide aids in forming a titanium contact with low electrical resistance. In existing processes, the titanium silicide can be formed using a salicide process in which the silicon used to form the titanium silicide comes from the silicon germanium layer.

Titanium contacts formed via a process that comprises forming a titanium layer on crystalline silicon germanium can be thermally unstable in that their resistance (contact resistance) increases after being subjected to subsequent annealing and other high-temperature processing steps that occur in a semiconductor device manufacturing process after contact formation. The back end of line (BEOL) portion of a semiconductor device manufacturing process can involve numerous annealing and other high-temperature processing steps, the cumulative effect of which can cause titanium contact resistance to increase by more than 50% in some cases. The creation of voids in the silicon germanium layer at the titanium silicide-silicon germanium interface during the annealing and other high-temperature processing steps is understood to be at least partially responsible for titanium contact thermal instability. The increased resistance of titanium contacts due to their thermal instability can impact the performance of transistors having silicon germanium layer source/drain regions.

Described herein are titanium contacts in which contact formation comprises the formation of a titanium silicide layer from a titanium layer in which the silicon for the titanium silicide layer is provided by exposure of the titanium layer to a silicon precursor, such as silane (disilane, trisilane, etc.) at an elevated temperature. A titanium silicide layer formed as such can help limit the amount of titanium and germanium interdiffusion that can occur at the titanium silicide-silicon germanium interface (and the resulting formation of voids in the silicon germanium layer) during subsequent annealing and other high-temperature processing steps. A titanium silicide formation process that does not scavenge silicon from a silicon germanium layer adjacent to a titanium layer can further reduce the creation of voids in the silicon germanium. Moreover, a surface region of a silicon germanium layer upon which a titanium layer is formed as part of a contact formation process can be preamorphized via boron and germanium implantation to further improve the robustness of the SiGe layer against microvoid development in subsequent annealing processing steps. The titanium contacts formed as described herein are thermally stable in that their resistance remains substantially unchanged after being subjected to downstream annealing and other high-temperature processes.

In the following description, specific details are set forth, but embodiments of the technologies described herein may be practiced without these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics.

Some embodiments may have some, all, or none of the features described for other embodiments. "First," "second," "third," and the like describe a common object and indicate different instances of like objects being referred to. Such adjectives do not imply objects so described must be in a given sequence, either temporally or spatially, in ranking, or any other manner. "Connected" may indicate elements are in direct physical or electrical contact with each other and "coupled" may indicate elements co-operate or interact with each other, but they may or may not be in direct physical or electrical contact. Furthermore, the terms "comprising," "including," "having," and the like, as used with respect to embodiments of the present disclosure, are synonymous. synonymous.

Terms modified by the word "substantially" include arrangements, orientations, spacings, or positions that vary slightly from the meaning of the unmodified term. For example, the portion of a first layer or feature that is substantially perpendicular to a second layer or feature can include a first layer or feature that is +/- 20 degrees from a second layer or feature, a first surface that is substantially parallel to a second surface can include a first surface that is within several degrees of parallel from the second surface, a volume that is substantially filled by a via can comprise voids in the via, and a first edge that is substantially aligned with a second edge can be misaligned on the order of ones of nanometers, a contact resistance value that is substantially unchanged after one or more annealing processes include contact resistance values that change by 5% or less relative to their value prior to being subjected to one or more annealing processes. As used herein, the term "about" in reference to a value of a feature (e.g., height, width, spacing) or upper and lower limits of a range of values for a feature includes features values that are within several percent of the stated feature value, feature value lower range limit, or feature value upper range limit.

In the following description, for purposes of explanation, numerous specific details are set forth in order to provide a thorough understanding thereof.

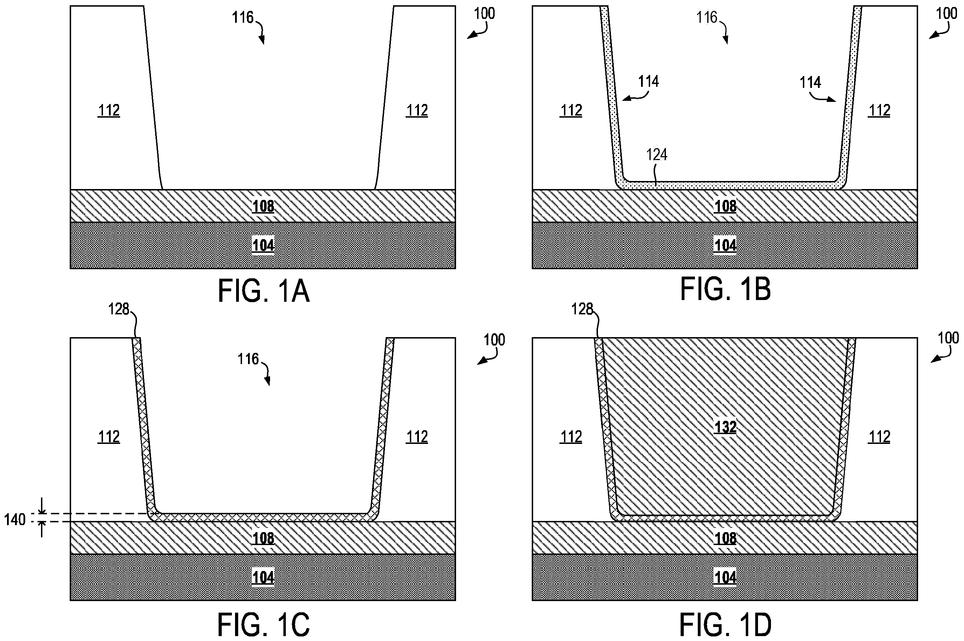

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components. For example, with reference to FIG. 1D, the trench metal 132 is located on the titanium silicide layer 128 whether the trench metal 132 is directly physically attached to the titanium silicide layer 128 or if there is an intervening layer (not shown in FIG. 1D), such as a barrier layer. In another example, with reference to FIG. 1B, the titanium layer 124 is located on the substrate 104, with an intervening silicon germanium layer 108.

As used herein, the term "adjacent" refers to layers or components that are in physical contact with each other. That is, there is no layer or component between the stated adjacent layers or components. For example, a layer X that is adjacent to a layer Y refers to a layer that is in physical contact with layer Y.

As used herein, the term "integrated circuit component" refers to a packaged or unpacked integrated circuit product. A packaged integrated circuit component comprises one or more integrated circuit dies mounted on a package substrate with the integrated circuit dies and package substrate encapsulated in a casing material, such as a metal, plastic, glass, or ceramic. In one example, a packaged integrated circuit component contains one or more processor units mounted on a substrate with an exterior surface of the substrate comprising a solder ball grid array (BGA). In one example of an unpackaged integrated circuit component, a single monolithic integrated circuit die comprises solder bumps attached to contacts on the die. The solder bumps allow the die to be directly attached to a printed circuit board. An integrated circuit component can comprise one or more of any computing system component described or referenced herein or any other computing system component, such as a processor unit (e.g., system-on-a-chip (SoC), processor core, graphics processor unit (GPU), accelerator, chipset processor), I/O controller, memory, or network interface controller.

Reference is now made to the drawings, which are not necessarily drawn to scale, wherein similar or same numbers may be used to designate same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

FIGS. 1A-1D illustrate a first example simplified process sequence for forming a titanium contact to silicon germanium. FIG. 1A illustrates a structure 100 comprising a substrate 104, a silicon germanium (SiGe) layer 108, and isolation regions 112 in which a trench 116 has been formed by a suitable etch process. The substrate 104 can comprise silicon and can be a bulk silicon wafer, a silicon-on-insulator wafer, or another suitable substrate. In some embodiments, the SiGe layer 108 comprises one or more p-type dopants, such as boron, indium, or gallium, or one or more n-type dopants, such as phosphorous, arsenic, or antimony. In some embodiments, the SiGe layer 108 can be an epitaxially grown layer with doping of the SiGe layer 108 occurring during epitaxial growth of the layer 108 (e.g., in situ doping).

The isolation regions 112 can comprise any suitable nitride or oxide, such as silicon dioxide (SiO₂, which is a material that comprises silicon and oxygen), carbon-doped silicon dioxide (C-doped SiO₂, also known as CDO or organosilicate glass, which is a material that comprises silicon, oxygen, and carbon), fluorine-doped silicon dioxide (F-doped SiO₂, also known as fluorosilicate glass, which is a material that comprises fluorine, silicon, and oxygen), hydrogen-doped silicon dioxide (H-doped SiO₂, which is a material that comprises silicon, oxygen, and hydrogen), or silicon nitride (Si₃N₄, which is a material that comprises silicon and nitrogen).

FIG. 1B illustrates the structure 100 after formation of a titanium layer 124. The titanium layer 124 can be formed by chemical vapor deposition (CVD), plasma enhanced chemical vapor deposition (PECVD), physical vapor deposition (e.g., such as sputtering), or other suitable deposition or other thin film formation processes. The titanium layer 124 is positioned adjacent to a portion of the silicon germanium layer 108 and sidewalls 114 of the isolation regions 112.

FIG. 1C illustrates the structure 100 after formation of a titanium disilicide or titanium silicide layer 128 from the titanium layer 124. The terms titanium silicide and titanium disilicide are used interchangeably herein to refer to a material having the chemical composition TiSi₂. To transform the titanium layer 124 to titanium silicide, the titanium layer 124 is exposed to a gaseous silicon precursor at an elevated temperature. The silicon precursor can be silane, disilane, trisilane, tetrasilane, or another suitable silicon precursor. In some embodiments, the silicon precursor flows over the structure 100. In some embodiments, the temperature of the chamber of a manufacturing tool in which the structure 100 is exposed to the silicon precursor is in the range of about 375-475 °C. The exposure of the titanium layer 124 to the silicon precursor can be performed in the same manufacturing tool (but in a different chamber) used for forming the titanium layer 124, thus allowing for an uninterrupted process flow between these two steps. That is, the structure 100 may not be removed from a semiconductor manufacturing tool between formation of the titanium layer 124 and transformation of the titanium layer 124 to titanium silicide. In some embodiments, the titanium silicide layer 128 comprises an amount of unreacted titanium. That is, the titanium silicide layer 128 can comprise titanium that did not react with the silicon precursor to form titanium silicide.

FIG. 1D illustrates the structure 100 after the trench 116 has been filled by a metal (trench metal) 132. The trench metal 132 can be formed by chemical vapor deposition (CVD), plasma enhanced chemical vapor deposition (PECVD), physical vapor deposition (e.g., such as sputtering), or other suitable fill process. The trench metal 132 can comprise tungsten, cobalt, titanium, gold, aluminum, molybdenum, chromium, and nickel, or another suitable metal or alloy. (Thus, while the contacts described herein are referred to as titanium contacts, the trench metal of the contact is not limited to titanium.) In some embodiments, a barrier layer can be formed on the titanium silicide layer 128 before fill of the trench 116 by the trench metal 132, with the barrier layer positioned between the titanium silicide layer 128 and the trench metal 132, to protect the titanium silicide layer 128 from oxygen and other contaminants. A barrier layer can comprise tantalum (Ta), tantalum nitride (which is a material that comprises titanium and nitrogen (e.g., TaN, Ta₂N, TasNs)), indium oxide (In₂O₃, which is a material that comprises indium and oxygen), tungsten nitride (which is a material that comprises tungsten and nitrogen (e.g., W₂N, WN, WN₂), titanium nitride (TiN, which is a material that comprises titanium and nitrogen), ruthenium, or another suitable material.

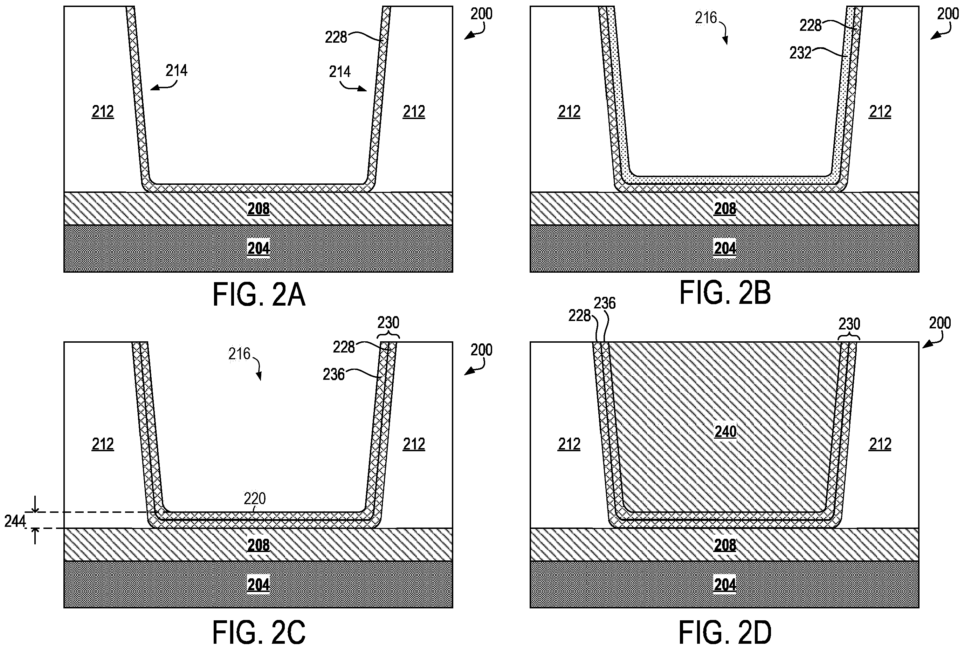

FIGS. 2A-2D illustrate a second example simplified process sequence for forming a titanium contact to silicon germanium. FIG. 2A illustrates a structure 200 comprising a substrate 204, a SiGe layer 208, and isolation regions 212 in which a trench 216 has been etched by a suitable etch process. A first titanium silicide layer 228 is positioned adjacent to sidewalls 214 of the isolation regions 212 and a portion of the silicon germanium layer 208. The layers and features of FIGS. 2A-2D can comprise the same materials as listed above for counterpart layers and features in FIGS. 1A-1D. The first titanium silicide layer 228 can have been formed in any of the manners described above for forming the titanium silicide layer 128 (e.g., through formation of a titanium layer subsequently exposed to a silicon precursor, such as silane, at an elevated temperature).

FIG. 2B illustrates the structure 200 after the formation of a second titanium layer 232 positioned adjacent to the first titanium silicide layer 228. The second titanium layer 232 can be performed by any of the thin film layer formation processes described above for forming the titanium layer 124. FIG. 2C illustrates the structure 200 after formation of a second titanium silicide layer 236 from the second titanium layer 232. Formation of the second titanium silicide layer 236 from the second titanium layer 232 can be formed in any manner described above for forming the titanium silicide layer 128 from the titanium layer 124. In embodiments where multiple titanium silicide layers are formed as part of a contact formation process, the multiple titanium silicide layers can be considered to be a single titanium silicide layer with constituent titanium silicide sublayers. For example, the structure 200 of FIGS. 2C-2D can be considered to have a single titanium silicide layer 230 with constituent titanium silicide sublayers 228 and 236. Individual titanium silicide layers may have variations in titanium and silicon concentration across the layer. Thus, a titanium silicide layer comprising multiple titanium silicide sublayers may have a repeating pattern of titanium and silicon concentration variations with the titanium and silicon concentration variations being repeated in the pattern being similar to that of a single titanium silicide layer.

FIG. 2D illustrates the structure 200 after the trench 216 has been filled by a trench metal 240. The trench metal 240 can be formed by any of the fill processes described above for forming the trench metal 132. The trench metal 240 can comprise tungsten, cobalt, titanium, gold, aluminum, molybdenum, chromium, and nickel, or another suitable metal or alloy. In some embodiments, a barrier layer can be formed on the second titanium silicide layer 236 before fill of the trench 216 and can be positioned between the second titanium silicide layer 236 and the trench metal 240. The barrier layer can comprise any of the barrier layer materials described above.

FIGS. 2A-2D illustrate a titanium contact formation process where a cycle of titanium layer formation followed by titanium silicide layer formation is performed twice. In other embodiments, the titanium layer formation-titanium silicide formation cycle can be performed three or more times. In some embodiments in which titanium contact formation comprises the formation of multiple titanium silicide layers, the same silicon precursor is used in forming the individual titanium silicide layers. In other embodiments, the silicon precursor used in forming at least one of the titanium silicide layers is different than the silicon precursor used in forming the other titanium silicide layers. In still other embodiments, a different silicon precursor can be used in the formation of each titanium silicide layer.

In some embodiments, the thickness of the titanium silicide layer (e.g., thickness 140 of the titanium silicide layer 128) or the combined thickness of multiple titanium silicide layers (e.g., combined thickness 244 of the titanium silicide layers 228 and 236) is about 5-6 nm. In some embodiments, this thickness is about 2-6 nm. Thus, in titanium contact formation processes where multiple titanium silicide layers are formed, the individual titanium silicide layers may be thinner than those formed in titanium contact formation processes where only one titanium silicide layer is formed. The formation of titanium contacts formed by the titanium contact formation technologies herein can allow for titanium silicide layers thicknesses (e.g., thickness 140, 244) that are greater than titanium silicide layer thicknesses in titanium contacts formed by other approaches.

Titanium contacts formed by the titanium contact formation technologies described herein can be thermally stable in that their contact resistance remains substantially unchanged after being subjected to subsequent annealing and other high-temperature processes. The thermal stability of the titanium contacts formed as described herein is understood to be at least the result of reduced interdiffusion between titanium and germanium across the titanium silicide-silicon germanium interface, which can reduce the creation of voids in the silicon germanium layer. The reduced interdiffusion is understood to be the result of a low amount (or no amount) of titanium in the titanium layer being left unreacted after formation of the titanium silicide layer. Thus, under similar processing conditions, the formation of multiple titanium silicide layers may be advantageous in that less titanium in a thinner titanium layer may be left unreacted after the titanium silicide formation process than one in a process in which a single thicker titanium layer is formed. With less titanium-germanium interdiffusion, the titanium silicide formation processes described herein may form a purer form of titanium silicide relative to existing titanium contact formation processes. This may provide for a lower titanium silicide layer resistance if the purer titanium silicide layer comprises a single phase of titanium silicide. Further, with the reduction (or absence) of voids at the titanium silicide-silicon germanium interface, the titanium silicide layer may have a substantially uniform thickness and consistent electrical conductivity across the span of the titanium silicide-silicon germanium interface.

The formation of titanium contacts using the technologies described herein may result in titanium silicide layers that have sharp interfaces with adjacent silicon germanium layers and trench metals due to a reduced amount of interdiffusion. For example, in some embodiments, the amount of germanium across a titanium silicide-silicon germanium boundary can decrease from a first germanium percentage concentration (e.g., 50% of the silicon germanium layer) on the silicon germanium layer-side of the boundary (e.g., boundaries 128-132, 228-240) to a second germanium percentage concentration of ten percent of the titanium silicide layer within 1.5 nm of the titanium silicide-silicon germanium boundary on the titanium silicide side of the boundary. Similarly, in some embodiments, the amount of trench metal across a titanium silicide layer-trench metal layer boundary can decrease from a first metal percentage concentration (e.g., 50% or more of the trench metal layer) on the trench metal layer-side of the boundary (e.g., boundaries 128-108, 228-208) to a second trench metal percentage concentration of ten percent of the titanium silicide layer within 1.5 nm from the titanium silicide-silicon germanium boundary on the titanium silicide side of the boundary.

In some embodiments, the silicon germanium layer (e.g., 108, 208) can be amorphized prior to formation of a titanium layer on the silicon germanium layer through the implantation of boron (e.g., boron-11) and germanium into the silicon germanium layer. In other embodiments, another element or combination of elements can be implanted into a SiGe layer to amorphize a portion of the SiGe layer. The dose and energy of the implanted boron and germanium are such that a region of the silicon germanium layer extends from a surface of the silicon germanium layer to a depth within the silicon germanium layer is amorphized. Amorphization of the silicon germanium layer prior to formation of the titanium layer can aid in the robustness of the silicon germanium layer against microvoid growth during subsequent annealing and other high-temperature processes and can thus contribute to the thermal stability of the titanium contacts.

Although the titanium contacts illustrated in FIGS. 1A-1D and 2A-2D are discussed in the context of contacts to silicon germanium layers, in other embodiments, titanium contacts can be formed to a silicon layer or substrate, or another suitable semiconductor layer or substrate.

The technologies for forming titanium contacts described herein can be utilized to form titanium contacts to SiGe layers that that are part of a source region or a drain region of a transistor, such as a planar FET, a FinFET, a gate-all-around FET (GAAFET), a stacked GAAFET, or another type of transistor. In other embodiments, the titanium contact formation technologies disclosed herein can be utilized to form titanium contacts to a backside of a wafer (the side of a wafer opposite to the side of the wafer upon which a plurality of active devices (e.g., electronic transistors, spintronic devices) are located).

The titanium contacts formed using the titanium contact formation technologies described herein can be used in any processor unit, integrated circuit component, or computing system described or referenced herein. Such titanium contacts can be fabricated as part of an integrated circuit structure. The integrated circuit structure can comprise a die substrate, such as a die substrate comprising silicon, and one or more interconnect or metal layers. A titanium contact formed as described herein can connect to a line of an interconnect or metal layer by a via or by being positioned adjacent to a line of a metal layer. The integrated circuit structure can comprise other types of devices, such as electronic transistors (transistors such as CMOS transistors that operate through control of the flow of electric current and that do not rely upon the switching of the magnetization of a layer or component for operation) and/or magnetoelectric spin-orbit (MESO) devices that use magnetoelectric switching to convert an input voltage/charge into a magnetic spin state (e.g., charge-to-spin conversion) and further uses spin-orbit transduction to convert the magnetic spin state back into an output charge/voltage (e.g., spin-to-charge conversion). An integrated circuit component comprising titanium contacts formed as described herein can be attached to a printed circuit board. In some embodiments, one or more additional integrated circuit components can be attached to the circuit board. In some embodiments, the printed circuit board and the integrated circuit component can be located in a computing device that comprises a housing that encloses the printed circuit board and the integrated circuit component.

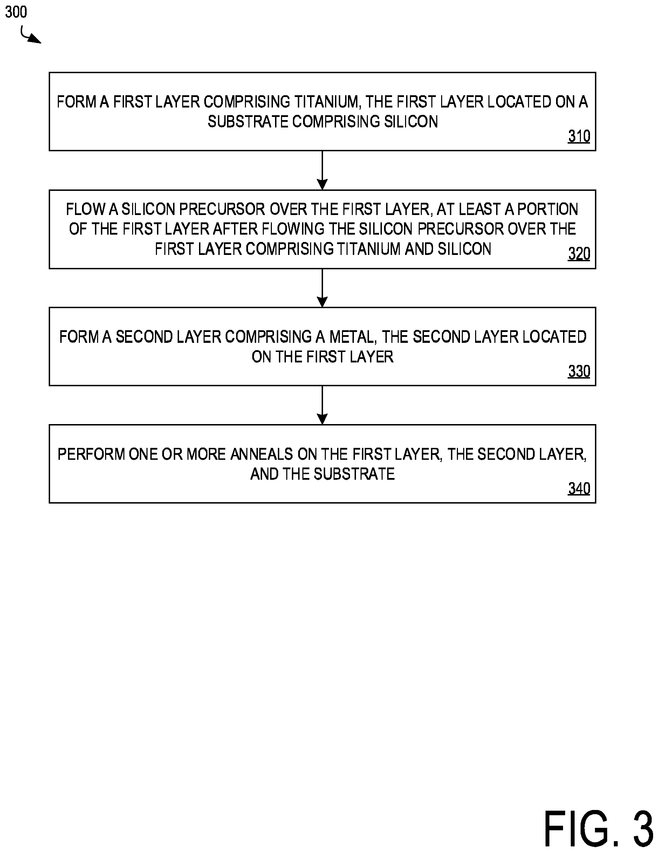

FIG. 3 is an example method of forming a titanium contact. The method 300 can be performed by a semiconductor device manufacturer. At 310, a first layer comprising titanium is formed, the first layer located on a substrate comprising silicon. At 320, a silicon precursor flows over the first layer, at least a portion of the first layer after the silicon precursor flows over the first layer comprising titanium and silicon. At 330, a second layer is formed comprising a metal, the second layer located on the first layer. At 340, one or more annealing processes are performed on the first layer, the second layer, and the substrate.

In some embodiments, the method 300 can comprise additional elements. For example, the silicon precursor of element 320 can be a first silicon precursor, the method 300 further comprising, after the first silicon precursor flows over the first layer and prior to forming the second layer: forming a third layer comprising titanium, the third layer positioned adjacent to the first layer; and flowing a second silicon precursor over the third layer, at least a portion of the third layer after flowing the silicon precursor over the second layer comprising titanium and silicon, the third layer located between the first layer and the second layer.

In some embodiments, the method can further comprise, after flowing the second silicon precursor over the third layer and prior to forming the second layer: forming a fourth layer comprising titanium, the fourth layer positioned adjacent to the third layer; and flowing a third silicon precursor over the fourth layer, at least a portion of the fourth layer after flowing the silicon precursor over the fourth layer comprising titanium and silicon, the third layer located between the first layer and the second layer.

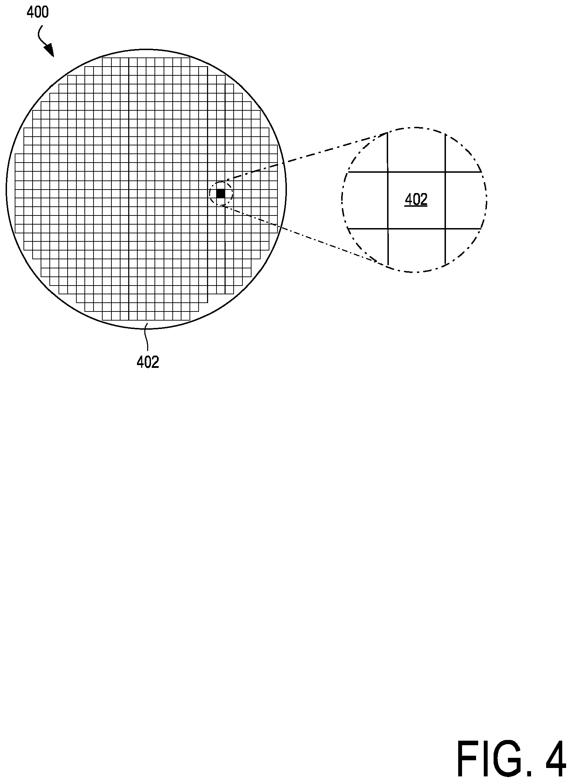

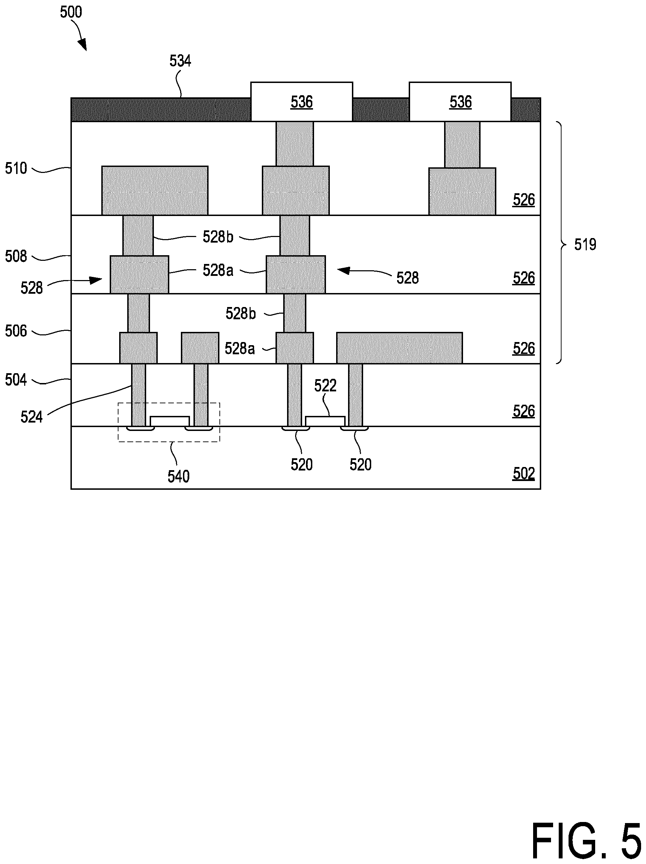

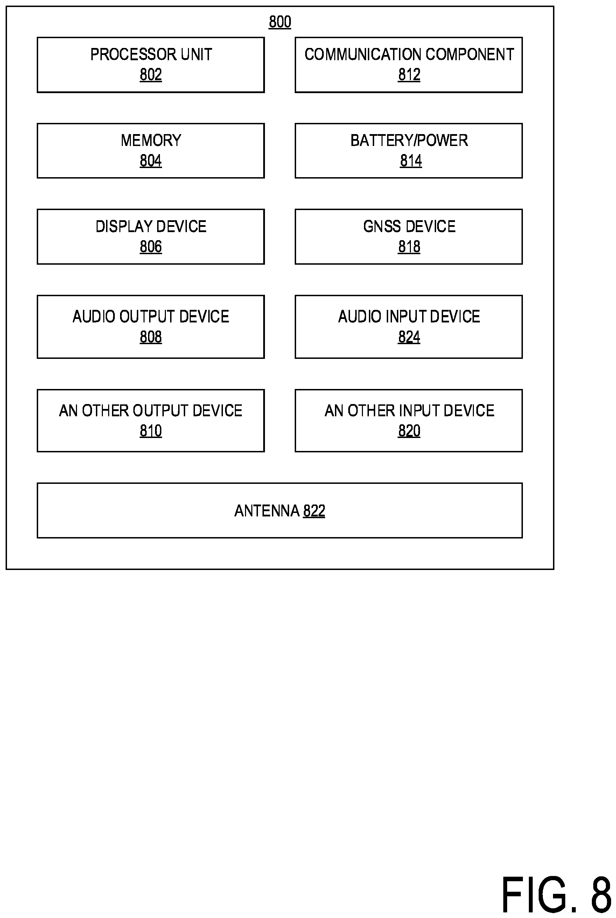

FIG. 4 is a top view of a wafer 400 and dies 402 that may be included in any of the microelectronic assemblies disclosed herein. The wafer 400 may be composed of semiconductor material and may include one or more dies 402 having integrated circuit structures formed on a surface of the wafer 400. The individual dies 402 may be a repeating unit of an integrated circuit product that includes any suitable integrated circuit. After the fabrication of the semiconductor product is complete, the wafer 400 may undergo a singulation process in which the dies 402 are separated from one another to provide discrete "chips" of the integrated circuit product. The die 402 may include one or more transistors (e.g., some of the transistors 540 of FIG. 5, discussed below), supporting circuitry to route electrical signals to the transistors, passive components (e.g., signal traces, resistors, capacitors, or inductors), and/or any other integrated circuit components. In some embodiments, the wafer 400 or the die 402 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 402. For example, a memory array formed by multiple memory devices may be formed on a same die 402 as a processor unit (e.g., the processor unit 802 of FIG. 8) or other logic that is configured to store information in the memory devices or execute instructions stored in the memory array. Various ones of the microelectronic assemblies disclosed herein may be manufactured using a die-to-wafer assembly technique in which some dies 502 are attached to a wafer 400 that include others of the dies 502, and the wafer 400 is subsequently singulated.

FIG. 5 is a cross-sectional side view of an integrated circuit device 500 that may include titanium contacts according to the technologies disclosed herein. One or more of the integrated circuit devices 500 may be included in one or more dies 402 (FIG. 4). The integrated circuit device 500 may be formed on a die substrate 502 (e.g., the wafer 400 of FIG. 4) and may be included in a die (e.g., the die 402 of FIG. 4). The die substrate 502 may be a semiconductor substrate composed of semiconductor material systems including, for example, n-type or p-type materials systems (or a combination of both). The die substrate 502 may include, for example, a crystalline substrate formed using a bulk silicon or a silicon-on-insulator (SOI) substructure. In some embodiments, the die substrate 502 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 502. Although a few examples of materials from which the die substrate 502 may be formed are described here, any material that may serve as a foundation for an integrated circuit device 500 may be used. The die substrate 502 may be part of a singulated die (e.g., the dies 402 of FIG. 4) or a wafer (e.g., the wafer 400 of FIG. 4).

The integrated circuit device 500 may include one or more device layers 504 disposed on the die substrate 502. The device layer 504 may include features of one or more transistors 540 (e.g., metal oxide semiconductor field-effect transistors (MOSFETs)) formed on the die substrate 502. The transistors 540 may include, for example, one or more source and/or drain (S/D) regions 520, a gate 522 to control current flow between the S/D regions 520, and one or more S/D contacts 524 to route electrical signals to/from the S/D regions 520. The S/D contacts 624 may be formed using any of the titanium contacts formation technologies described herein. The transistors 540 may include additional features not depicted for the sake of clarity, such as device isolation regions, gate contacts, and the like. The transistors 540 are not limited to the type and configuration depicted in FIG. 5 and may include a wide variety of other types and configurations such as, for example, planar transistors, non-planar transistors, or a combination of both. Non- planar transistors may include FinFET transistors, such as double-gate transistors or tri-gate transistors, and wrap-around or all-around gate transistors, such as nanoribbon, nanosheet, or nanowire transistors.

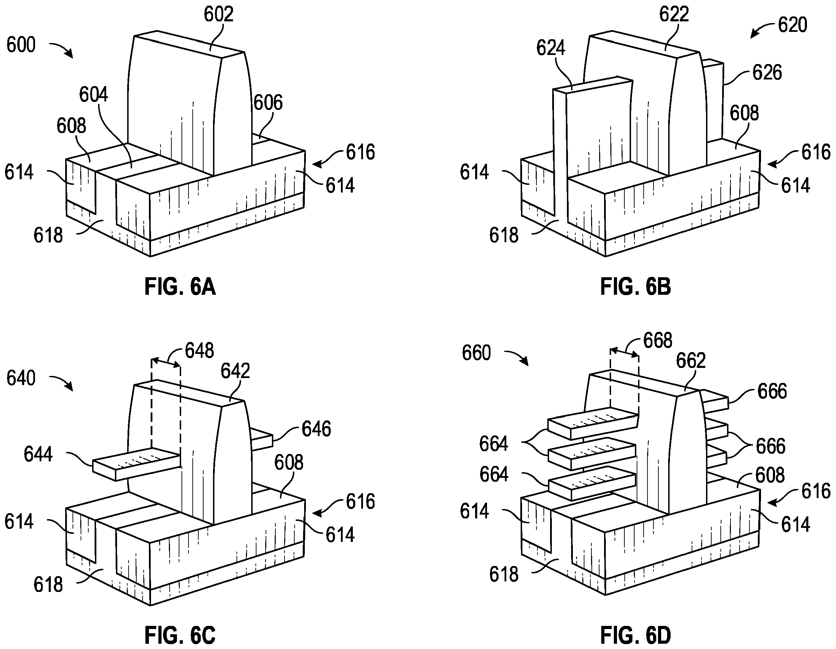

FIGS. 6A-6D are perspective views of an example planar FET, FinFET, gate-all-around FET, and stacked gate-all-around FET. The transistors illustrated in FIGS. 6A-6D are formed on a substrate 616 having a surface 608. Isolation regions 614 separate the source and drain regions of the transistors from other transistors and from a bulk region 618 of the substrate 616.

FIG. 6A is a perspective view of an example planar transistor 600 comprising a gate 602 that controls current flow between a source region 604 and a drain region 606. The transistor 600 is planar in that the source region 604 and the drain region 606 are planar with respect to the substrate surface 608.

FIG. 6B is a perspective view of an example FinFET transistor 620 comprising a gate 622 that controls current flow between a source region 624 and a drain region 626. The transistor 620 is non-planar in that the source region 624 and the drain region 626 comprise "fins" that extend upwards from the substrate surface 628. As the gate 622 encompasses three sides of the semiconductor fin that extends from the source region 624 to the drain region 626, the transistor 620 can be considered a tri-gate transistor. FIG. 6B illustrates one S/D fin extending through the gate 622, but multiple S/D fins can extend through the gate of a FinFET transistor.

FIG. 6C is a perspective view of a gate-all-around (GAA) transistor 640 comprising a gate 642 that controls current flow between a source region 644 and a drain region 646. The transistor 640 is non-planar in that the source region 644 and the drain region 646 are elevated from the substrate surface 628.

FIG. 6D is a perspective view of a GAA transistor 660 comprising a gate 662 that controls current flow between multiple elevated source regions 664 and multiple elevated drain regions 666. The transistor 660 is a stacked GAA transistor as the gate controls the flow of current between multiple elevated S/D regions stacked on top of each other. The transistors 640 and 660 are considered gate-all-around transistors as the gates encompass all sides of the semiconductor portions that extend from the source regions to the drain regions. The transistors 640 and 660 can alternatively be referred to as nanowire, nanosheet, or nanoribbon transistors depending on the width (e.g., widths 648 and 668 of transistors 640 and 660, respectively) of the semiconductor portions extending through the gate.

Returning to FIG. 5, a transistor 540 may include a gate 522 formed of at least two layers, a gate dielectric and a gate electrode. The gate dielectric may include one layer or a stack of layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor 540 is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For a PMOS transistor, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For an NMOS transistor, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, when viewed as a cross-section of the transistor 540 along the source-channel-drain direction, the gate electrode may consist of a U-shaped structure that includes a bottom portion substantially parallel to the surface of the die substrate 502 and two sidewall portions that are substantially perpendicular to the top surface of the die substrate 502. In other embodiments, at least one of the metal layers that form the gate electrode may simply be a planar layer that is substantially parallel to the top surface of the die substrate 502 and does not include sidewall portions substantially perpendicular to the top surface of the die substrate 502. In other embodiments, the gate electrode may consist of a combination of U-shaped structures and planar, non-U-shaped structures. For example, the gate electrode may consist of one or more U-shaped metal layers formed atop one or more planar, non-U-shaped layers.

In some embodiments, a pair of sidewall spacers may be formed on opposing sides of the gate stack to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of spacer pairs may be used; for instance, two pairs, three pairs, or four pairs of sidewall spacers may be formed on opposing sides of the gate stack.

The S/D regions 520 may be formed within the die substrate 502 adjacent to the gate 522 of individual transistors 540. The S/D regions 520 may be formed using an implantation/diffusion process or an etching/deposition process, for example. In the former process, dopants such as boron, aluminum, antimony, phosphorous, or arsenic may be ion-implanted into the die substrate 502 to form the S/D regions 520. An annealing process that activates the dopants and causes them to diffuse farther into the die substrate 502 may follow the ion-implantation process. In the latter process, the die substrate 502 may first be etched to form recesses at the locations of the S/D regions 520. An epitaxial deposition process may then be carried out to fill the recesses with material that is used to fabricate the S/D regions 520. In some implementations, the S/D regions 520 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 520 may be formed using one or more alternate semiconductor materials such as germanium or a group III-V material or alloy. In further embodiments, one or more layers of metal and/or metal alloys may be used to form the S/D regions 520.

Electrical signals, such as power and/or input/output (I/O) signals, may be routed to and/or from the devices (e.g., transistors 540) of the device layer 504 through one or more interconnect layers disposed on the device layer 504 (illustrated in FIG. 5 as interconnect layers 506-510). For example, electrically conductive features of the device layer 504 (e.g., the gate 522 and the S/D contacts 524) may be electrically coupled with the interconnect structures 528 of the interconnect layers 506-510. The one or more interconnect layers 506-510 may form a metallization stack (also referred to as an "ILD stack") 519 of the integrated circuit device 500.

The interconnect structures 528 may be arranged within the interconnect layers 506-510 to route electrical signals according to a wide variety of designs; in particular, the arrangement is not limited to the particular configuration of interconnect structures 528 depicted in FIG. 5 Although a particular number of interconnect layers 506-510 is depicted in FIG. 5, embodiments of the present disclosure include integrated circuit devices having more or fewer interconnect layers than depicted.

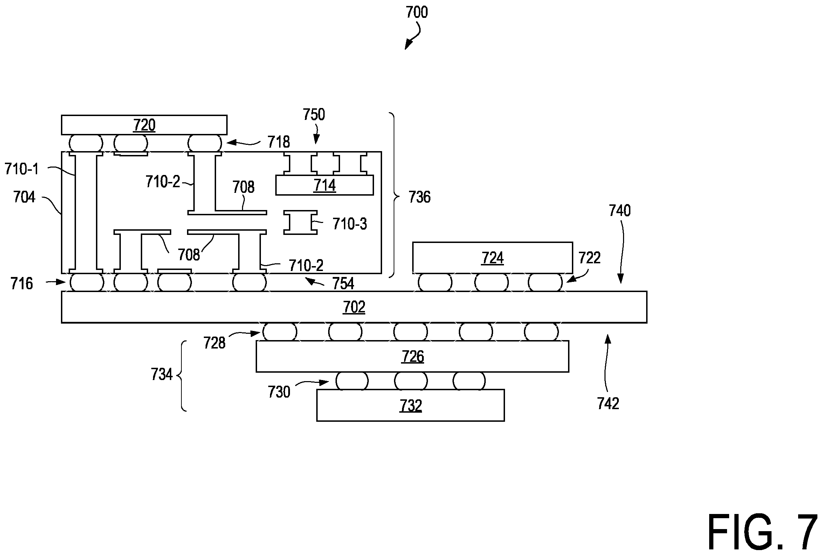

In some embodiments, the interconnect structures 528 may include lines 528a and/or vias 528b filled with an electrically conductive material such as a metal. The lines 528a may be arranged to route electrical signals in a direction of a plane that is substantially parallel with a surface of the die substrate 502 upon which the device layer 504 is formed. For example, the lines 528a may route electrical signals in a direction in and out of the page and/or in a direction across the page from the perspective of FIG. 7. The vias 528b may be arranged to route electrical signals in a direction of a plane that is substantially perpendicular to the surface of the die substrate 502 upon which the device layer 504 is formed. In some embodiments, the vias 528b may electrically couple lines 528a of different interconnect layers 506-510 together.

The interconnect layers 506-510 may include a dielectric material 526 disposed between the interconnect structures 528, as shown in FIG. 5. In some embodiments, dielectric material 526 disposed between the interconnect structures 528 in different ones of the interconnect layers 506-510 may have different compositions; in other embodiments, the composition of the dielectric material 526 between different interconnect layers 506-510 may be the same. The device layer 504 may include a dielectric material 526 disposed between the transistors 540 and a bottom layer of the metallization stack as well. The dielectric material 526 included in the device layer 504 may have a different composition than the dielectric material 526 included in the interconnect layers 506-510; in other embodiments, the composition of the dielectric material 526 in the device layer 504 may be the same as a dielectric material 526 included in any one of the interconnect layers 506-510.

A first interconnect layer 506 (referred to as Metal 1 or "M1") may be formed directly on the device layer 504. In some embodiments, the first interconnect layer 506 may include lines 528a and/or vias 528b, as shown. The lines 528a of the first interconnect layer 506 may be coupled with contacts (e.g., the S/D contacts 524) of the device layer 504. The vias 528b of the first interconnect layer 506 may be coupled with the lines 528a of a second interconnect layer 508.

The second interconnect layer 508 (referred to as Metal 2 or "M2") may be formed directly on the first interconnect layer 506. In some embodiments, the second interconnect layer 508 may include via 528b to couple the lines 528 of the second interconnect layer 508 with the lines 528a of a third interconnect layer 510. Although the lines 528a and the vias 528b are structurally delineated with a line within individual interconnect layers for the sake of clarity, the lines 528a and the vias 528b may be structurally and/or materially contiguous (e.g., simultaneously filled during a dual-damascene process) in some embodiments.

The third interconnect layer 510 (referred to as Metal 3 or "M3") (and additional interconnect layers, as desired) may be formed in succession on the second interconnect layer 508 according to similar techniques and configurations described in connection with the second interconnect layer 508 or the first interconnect layer 506. In some embodiments, the interconnect layers that are "higher up" in the metallization stack 519 in the integrated circuit device 500 (i.e., farther away from the device layer 504) may be thicker that the interconnect layers that are lower in the metallization stack 519, with lines 528a and vias 528b in the higher interconnect layers being thicker than those in the lower interconnect layers.

The integrated circuit device 500 may include a solder resist material 534 (e.g., polyimide or similar material) and one or more conductive contacts 536 formed on the interconnect layers 506-510. In FIG. 5, the conductive contacts 536 are illustrated as taking the form of bond pads. The conductive contacts 536 may be electrically coupled with the interconnect structures 528 and configured to route the electrical signals of the transistor(s) 540 to external devices. For example, solder bonds may be formed on the one or more conductive contacts 536 to mechanically and/or electrically couple an integrated circuit die including the integrated circuit device 500 with another component (e.g., a printed circuit board). The integrated circuit device 500 may include additional or alternate structures to route the electrical signals from the interconnect layers 506-510; for example, the conductive contacts 536 may include other analogous features (e.g., posts) that route the electrical signals to external components.

In some embodiments in which the integrated circuit device 500 is a double-sided die, the integrated circuit device 500 may include another metallization stack (not shown) on the opposite side of the device layer(s) 504. This metallization stack may include multiple interconnect layers as discussed above with reference to the interconnect layers 506-510, to provide conductive pathways (e.g., including conductive lines and vias) between the device layer(s) 504 and additional conductive contacts (not shown) on the opposite side of the integrated circuit device 500 from the conductive contacts 536.

In other embodiments in which the integrated circuit device 500 is a double-sided die, the integrated circuit device 500 may include one or more through silicon vias (TSVs) through the die substrate 502; these TSVs may make contact with the device layer(s) 504, and may provide conductive pathways between the device layer(s) 504 and additional conductive contacts (not shown) on the opposite side of the integrated circuit device 500 from the conductive contacts 536. In some embodiments, TSVs extending through the substrate can be used for routing power and ground signals from conductive contacts on the opposite side of the integrated circuit device 500 from the conductive contacts 536 to the transistors 540 and any other components integrated into the die 500, and the metallization stack 519 can be used to route I/O signals from the conductive contacts 536 to transistors 540 and any other components integrated into the die 500.

Multiple integrated circuit devices 500 may be stacked with one or more TSVs in the individual stacked devices providing connection between one of the devices to any of the other devices in the stack. For example, one or more high-bandwidth memory (HBM) integrated circuit dies can be stacked on top of a base integrated circuit die and TSVs in the HBM dies can provide connection between the individual HBM and the base integrated circuit die. Conductive contacts can provide additional connections between adjacent integrated circuit dies in the stack. In some embodiments, the conductive contacts can be fine-pitch solder bumps (microbumps).

FIG. 7 is a cross-sectional side view of an integrated circuit device assembly 700 that may include any of the microelectronic assemblies disclosed herein. The integrated circuit device assembly 700 includes a number of components disposed on a circuit board 702 (which may be a motherboard, system board, mainboard, etc.). The integrated circuit device assembly 700 includes components disposed on a first face 740 of the circuit board 702 and an opposing second face 742 of the circuit board 702; generally, components may be disposed on one or both faces 740 and 742. Any of the integrated circuit components discussed below with reference to the integrated circuit device assembly 700 may take the form of any suitable ones of the embodiments of the microelectronic assemblies disclosed herein.

In some embodiments, the circuit board 702 may be a printed circuit board (PCB) including multiple metal (or interconnect) layers separated from one another by layers of dielectric material and interconnected by electrically conductive vias. The individual metal layers comprise conductive traces. Any one or more of the metal layers may be formed in a desired circuit pattern to route electrical signals (optionally in conjunction with other metal layers) between the components coupled to the circuit board 702. In other embodiments, the circuit board 702 may be a non-PCB substrate. The integrated circuit device assembly 700 illustrated in FIG. 7 includes a package-on-interposer structure 736 coupled to the first face 740 of the circuit board 702 by coupling components 716. The coupling components 716 may electrically and mechanically couple the package-on-interposer structure 736 to the circuit board 702, and may include solder balls (as shown in FIG. 7), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. The coupling components 716 may serve as the coupling components illustrated or described for any of the substrate assembly or substrate assembly components described herein, as appropriate.

The package-on-interposer structure 736 may include an integrated circuit component 720 coupled to an interposer 704 by coupling components 718. The coupling components 718 may take any suitable form for the application, such as the forms discussed above with reference to the coupling components 716. Although a single integrated circuit component 720 is shown in FIG. 7, multiple integrated circuit components may be coupled to the interposer 704; indeed, additional interposers may be coupled to the interposer 704. The interposer 704 may provide an intervening substrate used to bridge the circuit board 702 and the integrated circuit component 720.

The integrated circuit component 720 may be a packaged or unpacked integrated circuit product that includes one or more integrated circuit dies (e.g., the die 402 of FIG. 4, the integrated circuit device 500 of FIG. 5) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one example of an unpackaged integrated circuit component 720, a single monolithic integrated circuit die comprises solder bumps attached to contacts on the die. The solder bumps allow the die to be directly attached to the interposer 704. The integrated circuit component 720 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 720 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 720 comprises multiple integrated circuit dies, they dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 720 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 704 may spread connections to a wider pitch or reroute a connection to a different connection. For example, the interposer 704 may couple the integrated circuit component 720 to a set of ball grid array (BGA) conductive contacts of the coupling components 716 for coupling to the circuit board 702. In the embodiment illustrated in FIG. 7, the integrated circuit component 720 and the circuit board 702 are attached to opposing sides of the interposer 704; in other embodiments, the integrated circuit component 720 and the circuit board 702 may be attached to a same side of the interposer 704. In some embodiments, three or more components may be interconnected by way of the interposer 704.

In some embodiments, the interposer 704 may be formed as a PCB, including multiple metal layers separated from one another by layers of dielectric material and interconnected by electrically conductive vias. In some embodiments, the interposer 704 may be formed of an epoxy resin, a fiberglass-reinforced epoxy resin, an epoxy resin with inorganic fillers, a ceramic material, or a polymer material such as polyimide. In some embodiments, the interposer 704 may be formed of alternate rigid or flexible materials that may include the same materials described above for use in a semiconductor substrate, such as silicon, germanium, and other group III-V and group IV materials. The interposer 704 may include metal interconnects 708 and vias 710, including but not limited to through hole vias 710-1 (that extend from a first face 750 of the interposer 704 to a second face 754 of the interposer 704), blind vias 710-2 (that extend from the first or second faces 750 or 754 of the interposer 704 to an internal metal layer), and buried vias 710-3 (that connect internal metal layers).

In some embodiments, the interposer 704 can comprise a silicon interposer. Through silicon vias (TSV) extending through the silicon interposer can connect connections on a first face of a silicon interposer to an opposing second face of the silicon interposer. In some embodiments, an interposer 704 comprising a silicon interposer can further comprise one or more routing layers to route connections on a first face of the interposer 704 to an opposing second face of the interposer 704.

The interposer 704 may further include embedded devices 714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 704. The package-on-interposer structure 736 may take the form of any of the package-on-interposer structures known in the art. In embodiments where the interposer is a non-printed circuit board

The integrated circuit device assembly 700 may include an integrated circuit component 724 coupled to the first face 740 of the circuit board 702 by coupling components 722. The coupling components 722 may take the form of any of the embodiments discussed above with reference to the coupling components 716, and the integrated circuit component 724 may take the form of any of the embodiments discussed above with reference to the integrated circuit component 720.

The integrated circuit device assembly 700 illustrated in FIG. 7 includes a package-on-package structure 734 coupled to the second face 742 of the circuit board 702 by coupling components 728. The package-on-package structure 734 may include an integrated circuit component 726 and an integrated circuit component 732 coupled together by coupling components 730 such that the integrated circuit component 726 is disposed between the circuit board 702 and the integrated circuit component 732. The coupling components 728 and 730 may take the form of any of the embodiments of the coupling components 716 discussed above, and the integrated circuit components 726 and 732 may take the form of any of the embodiments of the integrated circuit component 720 discussed above. The package-on-package structure 734 may be configured in accordance with any of the package-on-package structures known in the art.

FIG. 8 is a block diagram of an example electrical device 800 that may include an integrated circuit component comprising titanium contacts formed according to the technologies disclosed herein. For example, any suitable ones of the components of the electrical device 800 may include one or more of the integrated circuit device assemblies 700, integrated circuit components 720, integrated circuit devices 500, or integrated circuit dies 402 disclosed herein, and may be arranged in any of the microelectronic assemblies disclosed herein. A number of components are illustrated in FIG. 8 as included in the electrical device 800, but any one or more of these components may be omitted or duplicated, as suitable for the application. In some embodiments, some or all of the components included in the electrical device 800 may be attached to one or more motherboards mainboards, or system boards. In some embodiments, one or more of these components are fabricated onto a single system-on-a-chip (SoC) die.

Additionally, in various embodiments, the electrical device 800 may not include one or more of the components illustrated in FIG. 8, but the electrical device 800 may include interface circuitry for coupling to the one or more components. For example, the electrical device 800 may not include a display device 806, but may include display device interface circuitry (e.g., a connector and driver circuitry) to which a display device 806 may be coupled. In another set of examples, the electrical device 800 may not include an audio input device 824 or an audio output device 808, but may include audio input or output device interface circuitry (e.g., connectors and supporting circuitry) to which an audio input device 824 or audio output device 808 may be coupled.

The electrical device 800 may include one or more processor units 802 (e.g., one or more processor units). As used herein, the terms "processor unit", "processing unit" or "processor" may refer to any device or portion of a device that processes electronic data from registers and/or memory to transform that electronic data into other electronic data that may be stored in registers and/or memory. The processor unit 802 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 800 may include a memory 804, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 804 may include memory that is located on the same integrated circuit die as the processor unit 802. This memory may be used as cache memory (e.g., Level 1 (L1), Level 2 (L2), Level 3 (L3), Level 4 (L4), Last Level Cache (LLC)) and may include embedded dynamic random access memory (eDRAM) or spin transfer torque magnetic random access memory (STT-MRAM).

In some embodiments, the electrical device 800 can comprise one or more processor units 802 that are heterogeneous or asymmetric to another processor unit 802 in the electrical device 800. There can be a variety of differences between the processing units 802 in a system in terms of a spectrum of metrics of merit including architectural, microarchitectural, thermal, power consumption characteristics, and the like. These differences can effectively manifest themselves as asymmetry and heterogeneity among the processor units 802 in the electrical device 800.

In some embodiments, the electrical device 800 may include a communication component 812 (e.g., one or more communication components). For example, the communication component 812 can manage wireless communications for the transfer of data to and from the electrical device 800. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 812 may operate in accordance with other wireless protocols in other embodiments. The electrical device 800 may include an antenna 822 to facilitate wireless communications and/or to receive other wireless communications (such as AM or FM radio transmissions).

In some embodiments, the communication component 812 may manage wired communications, such as electrical, optical, or any other suitable communication protocols (e.g., IEEE 802.3 Ethernet standards). As noted above, the communication component 812 may include multiple communication components. For instance, a first communication component 812 may be dedicated to shorter-range wireless communications such as Wi-Fi or Bluetooth, and a second communication component 812 may be dedicated to longer-range wireless communications such as global positioning system (GPS), EDGE, GPRS, CDMA, WiMAX, LTE, EV-DO, or others. In some embodiments, a first communication component 812 may be dedicated to wireless communications, and a second communication component 812 may be dedicated to wired communications.

The electrical device 800 may include battery/power circuitry 814. The battery/power circuitry 814 may include one or more energy storage devices (e.g., batteries or capacitors) and/or circuitry for coupling components of the electrical device 800 to an energy source separate from the electrical device 800 (e.g., AC line power).

The electrical device 800 may include a display device 806 (or corresponding interface circuitry, as discussed above). The display device 806 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 800 may include an audio output device 808 (or corresponding interface circuitry, as discussed above). The audio output device 808 may include any embedded or wired or wirelessly connected external device that generates an audible indicator, such speakers, headsets, or earbuds.

The electrical device 800 may include an audio input device 824 (or corresponding interface circuitry, as discussed above). The audio input device 824 may include any embedded or wired or wirelessly connected device that generates a signal representative of a sound, such as microphones, microphone arrays, or digital instruments (e.g., instruments having a musical instrument digital interface (MIDI) output). The electrical device 800 may include a Global Navigation Satellite System (GNSS) device 818 (or corresponding interface circuitry, as discussed above), such as a Global Positioning System (GPS) device. The GNSS device 818 may be in communication with a satellite-based system and may determine a geolocation of the electrical device 800 based on information received from one or more GNSS satellites, as known in the art.

The electrical device 800 may include an other output device 810 (or corresponding interface circuitry, as discussed above). Examples of the other output device 810 may include an audio codec, a video codec, a printer, a wired or wireless transmitter for providing information to other devices, or an additional storage device.

The electrical device 800 may include an other input device 820 (or corresponding interface circuitry, as discussed above). Examples of the other input device 820 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 800 may have any desired form factor, such as a hand-held or mobile electrical device (e.g., a cell phone, a smart phone, a mobile internet device, a music player, a tablet computer, a laptop computer, a 2-in-1 convertible computer, a portable all-in-one computer, a netbook computer, an ultrabook computer, a personal digital assistant (PDA), an ultra mobile personal computer, a portable gaming console, etc.), a desktop electrical device, a server, a rack-level computing solution (e.g., blade, tray or sled computing systems), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 800 may be any other electronic device that processes data. In some embodiments, the electrical device 800 may comprise multiple discrete physical components. Given the range of devices that the electrical device 800 can be manifested as in various embodiments, in some embodiments, the electrical device 800 can be referred to as a computing device or a computing system.

As used in this application and the claims, a list of items joined by the term "and/or" can mean any combination of the listed items. For example, the phrase "A, B and/or C" can mean A; B; C; A and B; A and C; B and C; or A, B and C. As used in this application and the claims, a list of items joined by the term "at least one of" can mean any combination of the listed terms. For example, the phrase "at least one of A, B or C" can mean A; B; C; A and B; A and C; B and C; or A, B, and C. Moreover, as used in this application and the claims, a list of items joined by the term "one or more of" can mean any combination of the listed terms. For example, the phrase "one or more of A, B and C" can mean A; B; C; A and B; A and C; B and C; or A, B, and C.

As used in this application and the claims, a list of items stated or recited as having a trait, feature, etc. preceded by the word "individual" or "respective" means that all of the items in the list possess the stated or recited trait, feature, etc. For example, the phrase "individual of A, B, or C, comprise a sidewall" or "respective of A, B, or C, comprise a sidewall" means that A comprises a sidewall, B comprises sidewall, and C comprises a sidewall.

## Claims

1. A method (300) comprising:
amorphizing a substrate comprising silicon via boron and germanium implantation;
forming (310) a first layer comprising titanium, the first layer located on the substrate comprising silicon;
flowing (320) a silicon precursor over the first layer, at least a portion of the first layer after flowing the silicon precursor over the first layer comprising titanium and silicon;
forming (330) a second layer comprising a metal, the second layer located on the first layer; and
performing (340) one or more annealing processes on the first layer, the second layer, and the substrate.

2. The method (300) of claim 1, wherein the portion of the first layer comprising titanium and silicon after flowing the silicon precursor over the first layer comprises titanium silicide.

3. The method (300) of claim 1 or 2, wherein the silicon precursor comprises silane.

4. The method (300) of claim 1 or 2, wherein the silicon precursor comprises disilane, trisilane, or tetrasilane.

5. The method (300) of any one of claims 1-4, wherein the silicon precursor is a first silicon precursor, the method (300) further comprising, after flowing the first silicon precursor over the first layer and prior to forming the second layer:
forming a third layer comprising titanium, the third layer positioned adjacent to the first layer; and
flowing a second silicon precursor over the third layer, at least a portion of the third layer after flowing the silicon precursor over the second layer comprising titanium and silicon, the third layer located between the first layer and the second layer.

6. The method (300) of claim 5, wherein the first silicon precursor comprises silane, disilane, trisilane, or tetrasilane and the second silicon precursor comprises silane, disilane, trisilane, or tetrasilane.

7. The method (300) of claim 6, wherein the first silicon precursor is different than the second silicon precursor.

8. The method (300) of any one of claims 5-7, the method (300) further comprising, after flowing the second silicon precursor over the third layer and prior to forming the second layer:
forming a fourth layer comprising titanium, the fourth layer positioned adjacent to the third layer; and
flowing a third silicon precursor over the fourth layer, at least a portion of the fourth layer after flowing the silicon precursor over the fourth layer comprising titanium and silicon, the fourth layer located between the third layer and the second layer.

9. The method (300) of claim 8, wherein the first silicon precursor comprises silane, disilane, trisilane, or tetrasilane, the second silicon precursor comprises silane, disilane, trisilane, or tetrasilane, and the third silicon precursor comprises silane, disilane, trisilane, or tetrasilane.

10. The method (300) of any one of claims 1-9, wherein the first silicon precursor, the second silicon precursor, and the third silicon precursor are the same.

11. The method (300) of any one of claims 1-9, wherein two of the first silicon precursor, the second silicon precursor, and the third silicon precursor are the same.

12. The method (300) of any one of claims 1-9, wherein the first silicon precursor, the second silicon precursor, and the third silicon precursor are all different.

13. The method (300) of any one of claims 1-12, wherein the first layer is adjacent to a third layer comprising silicon and germanium, the third layer positioned between the first layer and the substrate, the third layer positioned adjacent to the substrate.

14. The method (300) of any one of claims 1-13, wherein a thickness of the first layer is in a range of about 2-6 nm.

15. The method (300) of any one of claims 1-14, wherein the metal of the second layer comprises cobalt or tungsten.

## Patentansprüche

1. Verfahren (300), umfassend:
Amorphisieren eines Substrats, das Silicium umfasst, mittels Bor- und Germaniumimplantation;
Ausbilden (310) einer ersten Schicht, die Titan umfasst, wobei die erste Schicht sich auf dem Silicium umfassenden Substrat befindet;
Strömenlassen (320) eines Siliciumvorläufers über die erste Schicht, wobei wenigstens ein Abschnitt der ersten Schicht nach dem Strömenlassen des Siliciumvorläufers über die erste Schicht Titan und Silicium umfasst;
Ausbilden (330) einer zweiten Schicht, die ein Metall umfasst, wobei die zweite Schicht sich auf der ersten Schicht befindet; und
Durchführen (340) eines oder mehrerer Glühvorgänge bezüglich der ersten Schicht, der zweiten Schicht und des Substrats.

2. Verfahren (300) nach Anspruch 1, wobei der Abschnitt der ersten Schicht, der nach dem Strömenlassen des Siliciumvorläufers über die erste Schicht Titan und Silicium umfasst, Titansilicid umfasst.

3. Verfahren (300) nach Anspruch 1 oder 2, wobei der Siliciumvorläufer Silan umfasst.

4. Verfahren (300) nach Anspruch 1 oder 2, wobei der Siliciumvorläufer Disilan, Trisilan oder Tetrasilan umfasst.

5. Verfahren (300) nach einem der Ansprüche 1-4, wobei der Siliciumvorläufer ein erster Siliciumvorläufer ist, wobei das Verfahren (300) nach dem Strömenlassen des ersten Siliciumvorläufers über die erste Schicht und vor dem Ausbilden der zweiten Schicht ferner Folgendes umfasst:
Ausbilden einer dritten Schicht, die Titan umfasst, wobei die dritte Schicht der ersten Schicht benachbart angeordnet ist; und
Strömenlassen eines zweiten Siliciumvorläufers über die dritte Schicht, wobei wenigstens ein Abschnitt der dritten Schicht nach dem Strömenlassen des Siliciumvorläufers über die zweite Schicht Titan und Silicium umfasst, wobei die dritte Schicht sich zwischen der ersten Schicht und der zweiten Schicht befindet.

6. Verfahren (300) nach Anspruch 5, wobei der erste Siliciumvorläufer Silan, Disilan, Trisilan oder Tetrasilan umfasst und der zweite Siliciumvorläufer Silan, Disilan, Trisilan oder Tetrasilan umfasst.

7. Verfahren (300) nach Anspruch 6, wobei der erste Siliciumvorläufer anders als der zweite Siliciumvorläufer ist.

8. Verfahren (300) nach einem der Ansprüche 5-7, wobei das Verfahren (300) nach dem Strömenlassen des zweiten Siliciumvorläufers über die dritte Schicht und vor dem Ausbilden der zweiten Schicht ferner Folgendes umfasst:
Ausbilden einer vierten Schicht, die Titan umfasst, wobei die vierte Schicht der dritten Schicht benachbart angeordnet ist; und
Strömenlassen eines dritten Siliciumvorläufers über die vierte Schicht, wobei wenigstens ein Abschnitt der vierten Schicht nach dem Strömenlassen des Siliciumvorläufers über die vierte Schicht Titan und Silicium umfasst, wobei die vierte Schicht sich zwischen der dritten Schicht und der zweiten Schicht befindet.

9. Verfahren (300) nach Anspruch 8, wobei der erste Siliciumvorläufer Silan, Disilan, Trisilan oder Tetrasilan umfasst, der zweite Siliciumvorläufer Silan, Disilan, Trisilan oder Tetrasilan umfasst und der dritte Siliciumvorläufer Silan, Disilan, Trisilan oder Tetrasilan umfasst.

10. Verfahren (300) nach einem der Ansprüche 1-9, wobei der erste Siliciumvorläufer, der zweite Siliciumvorläufer und der dritte Siliciumvorläufer gleich sind.

11. Verfahren (300) nach einem der Ansprüche 1-9, wobei zwei aus dem ersten Siliciumvorläufer, dem zweiten Siliciumvorläufer und dem dritten Siliciumvorläufer gleich sind.

12. Verfahren (300) nach einem der Ansprüche 1-9, wobei der erste Siliciumvorläufer, der zweite Siliciumvorläufer und der dritte Siliciumvorläufer alle verschieden sind.

13. Verfahren (300) nach einem der Ansprüche 1-12, wobei die erste Schicht einer dritten Schicht benachbart ist, die Silicium und Germanium umfasst, wobei die dritte Schicht zwischen der ersten Schicht und dem Substrat angeordnet ist, die dritte Schicht dem Substrat benachbart angeordnet ist.

14. Verfahren (300) nach einem der Ansprüche 1-13, wobei eine Dicke der ersten Schicht in einem Bereich von etwa 2-6 nm liegt.

15. Verfahren (300) nach einem der Ansprüche 1-14, wobei das Metall der zweiten Schicht Cobalt oder Wolfram umfasst.

## Revendications

1. Procédé (300) comprenant :
l'amorphisation d'un substrat comprenant du silicium par implantation de bore et de germanium ;
la formation (310) d'une première couche comprenant du titane, la première couche étant située sur le substrat comprenant du silicium ;
l'écoulement (320) d'un précurseur de silicium sur la première couche, au moins une partie de la première couche après écoulement du précurseur de silicium sur la première couche comprenant du titane et du silicium ;
la formation (330) d'une deuxième couche comprenant un métal, la deuxième couche étant située sur la première couche ; et
la réalisation (340) d'un ou plusieurs traitements de recuit sur la première couche, la deuxième couche et le substrat.

2. Procédé (300) selon la revendication 1, dans lequel la partie de la première couche comprenant du titane et du silicium après écoulement du précurseur de silicium sur la première couche comprend du siliciure de titane.

3. Procédé (300) selon la revendication 1 ou 2, dans lequel le précurseur de silicium comprend du silane.

4. Procédé (300) selon la revendication 1 ou 2, dans lequel le précurseur de silicium comprend du disilane, du trisilane ou du tétrasilane.

5. Procédé (300) selon l'une quelconque des revendications 1 à 4, dans lequel le précurseur de silicium est un premier précurseur de silicium, le procédé (300) comprenant en outre, après l'écoulement du premier précurseur de silicium sur la première couche et avant la formation de la deuxième couche :
la formation d'une troisième couche comprenant du titane, la troisième couche étant positionnée de manière adjacente à la première couche ; et
l'écoulement d'un deuxième précurseur de silicium sur la troisième couche, au moins une partie de la troisième couche après écoulement du précurseur de silicium sur la deuxième couche comprenant du titane et du silicium, la troisième couche étant située entre la première couche et la deuxième couche.

6. Procédé (300) selon la revendication 5, dans lequel le premier précurseur de silicium comprend du silane, du disilane, du trisilane ou du tétrasilane, et le deuxième précurseur de silicium comprend du silane, du disilane, du trisilane ou du tétrasilane.

7. Procédé (300) selon la revendication 6, dans lequel le premier précurseur de silicium est différent du deuxième précurseur de silicium.

8. Procédé (300) selon l'une quelconque des revendications 5 à 7, le procédé (300) comprenant en outre, après l'écoulement du deuxième précurseur de silicium sur la troisième couche et avant la formation de la deuxième couche :
la formation d'une quatrième couche comprenant du titane, la quatrième couche étant positionnée de manière adjacente à la troisième couche ; et
l'écoulement d'un troisième précurseur de silicium sur la quatrième couche, au moins une partie de la quatrième couche après écoulement du précurseur de silicium sur la quatrième couche comprenant du titane et du silicium, la quatrième couche étant située entre la troisième couche et la deuxième couche.

9. Procédé (300) selon la revendication 8, dans lequel le premier précurseur de silicium comprend du silane, du disilane, du trisilane ou du tétrasilane, le deuxième précurseur de silicium comprend du silane, du disilane, du trisilane ou du tétrasilane, et le troisième précurseur de silicium comprend du silane, du disilane, du trisilane ou du tétrasilane.

10. Procédé (300) selon l'une quelconque des revendications 1 à 9, dans lequel le premier précurseur de silicium, le deuxième précurseur de silicium et le troisième précurseur de silicium sont identiques.

11. Procédé (300) selon l'une quelconque des revendications 1 à 9, dans lequel deux précurseurs parmi le premier précurseur de silicium, le deuxième précurseur de silicium et le troisième précurseur de silicium sont identiques.

12. Procédé (300) selon l'une quelconque des revendications 1 à 9, dans lequel le premier précurseur de silicium, le deuxième précurseur de silicium et le troisième précurseur de silicium sont tous différents.

13. Procédé (300) selon l'une quelconque des revendications 1 à 12, dans lequel la première couche est adjacente à une troisième couche comprenant du silicium et du germanium, la troisième couche étant positionnée entre la première couche et le substrat, la troisième couche étant positionnée de manière adjacente au substrat.

14. Procédé (300) selon l'une quelconque des revendications 1 à 13, dans lequel une épaisseur de la première couche se situe dans une plage d'environ 2-6 nm.

15. Procédé (300) selon l'une quelconque des revendications 1 à 14, dans lequel le métal de la deuxième couche comprend du cobalt ou du tungstène.
